**Europäisches Patentamt**

**European Patent Office**

**Office européen des brevets**

(19)

(11) Publication number : **0 425 275 B1**

(12) # EUROPEAN PATENT SPECIFICATION

(45) Date of publication of patent specification :
**18.01.95 Bulletin 95/03**

(51) Int. Cl.⁶ : **G11C 8/00,** G11C 11/408, G11C 5/06

(21) Application number : **90311667.1**

(22) Date of filing : **24.10.90**

(54) **Address input circuitry of a semiconductor memory device.**

(30) Priority : **24.10.89 JP 274928/89**

(43) Date of publication of application :
**02.05.91 Bulletin 91/18**

(45) Publication of the grant of the patent :
**18.01.95 Bulletin 95/03**

(84) Designated Contracting States :
**DE FR GB**

(56) References cited :
**GB-A- 2 087 151**
**GB-A- 2 091 008**
**US-A- 3 638 202**

(73) Proprietor : **FUJITSU LIMITED**
**1015, Kamikodanaka**
**Nakahara-ku**
**Kawasaki-shi Kanagawa 211 (JP)**

(72) Inventor : **Kohno, Tohru, 503, Beans Mansion**
**2-42-13, Tenno-cho,**
**Hodogaya-ku**
**Yokohama-shi, Kanagawa 240 (JP)**

(74) Representative : **Fane, Christopher Robin King**
**et al**
**HASELTINE LAKE & CO.**
**Hazlitt House**
**28 Southampton Buildings**
**Chancery Lane**
**London, WC2A 1AT (GB)**

EP 0 425 275 B1

## Description

The present invention relates to address input circuitry of a semiconductor memory device such as a dynamic random access memory (DRAM) having an address input operable to receive an address signal made up of a plurality of address bits, such as known from GB 2.091.008 and as indicated in the preamble of Claim 1.

In a typical DRAM device including a semiconductor chip, respective address input circuits receiving respective address bits of an address signal are generally arranged along a periphery of the chip. Thus, a length of wiring (interconnection) extending from an internal driving circuit, for driving the address input circuits, to each address input circuit is generally different for each address input circuit. In this case, when a control signal for the address inputting is output by the internal driving circuit to each address input circuit, it is propagated along individual wiring portions of different respective lengths and reaches the respective address input circuits at different respective times. Thus, a problem can arise in that a setup time of the address signal and a holding time thereof, which times are effectively determined for each individual address bit by the timing of the control signal reaching the associated address input circuit, can vary from one address input circuit to another.

Also, to compensate for such variation, a certain margin must be allowed for a cycle time for address accessing. This, however, causes a drawback in that it may be impossible to carry out the access operation at a sufficiently high speed. In a case where the margin is insufficient, another drawback can occur in that an incorrect access operation is carried out.

An embodiment of the present invention can provide a semiconductor memory device in which dispersion in the respective values of the row address setup time and row address hold time for the different address signal bits can be desirably small, regardless of the location of address input terminals, thereby facilitating reliable accessing at an desirably high speed.

According to the present invention, there is provided a semiconductor memory device including: a plurality of address input circuits disposed dispersively; an internal driving circuit outputting a plurality of control signals each driving a corresponding at least one of the plurality of address input circuits; and a signal propagation control unit, operatively connected between the internal driving circuit and the plurality of address input circuits, for controlling a respective signal propagation of the plurality of control signals such that a respective amount of signal propagation delay in each of a plurality of wirings transmitting the plurality of control signals, respectively, is made substantially equal between each wiring.

Reference will now be made, by way of example, to the accompanying drawings, in which:

Fig. 1 is a schematic view of a chip of a semiconductor memory device, for illustrating a typical location of a first stage of an address input circuit on the chip;

Fig. 2 is a circuit diagram of the first stage of the address input circuit in a previously-considered semiconductor memory device;

Fig. 3 is a timing chart illustrating the operation of the circuit shown in Fig. 2;

Fig. 4 is a block diagram of address input circuitry in a semiconductor memory device embodying the present invention;

Fig. 5 is a circuit diagram of a first stage of an address input circuit in a semiconductor memory device according to an embodiment of the present invention;

Fig. 6 is a timing chart illustrating the operation of the circuit shown in Fig. 5;

Fig. 7 is a circuit diagram illustrating another example of the first stage of address input circuitry embodying the present invention; and

Fig. 8 is a timing chart illustrating the operation of the circuitry shown in Fig. 7.

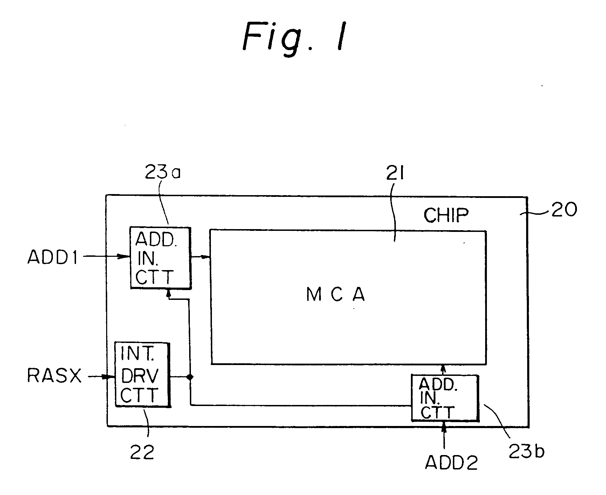

Figure 1 schematically shows a typical location of the first stage of an address input circuit on a chip.

In the illustration, reference 20 denotes a chip; reference 21 denotes a memory cell array (MCA) including a memory cell, a sense amplifier, a decoding circuit, and the like; reference 22 denotes an internal driving circuit responsive to an active low row address strobe signal RASX; and references 23a and 23b denote address input circuits responsive to address signals ADD1 and ADD2, respectively. A plurality of address input circuits (for simplification, only two circuits 23a, 23b are shown) are controlled by the internal driving circuit 22 and arrayed along the periphery of the memory cell array 21, i.e., on shorter sides and/or longer sides thereof. Accordingly, the length of a wiring extending from the internal driving circuit 22 to the address input circuit 23a is of course different from that extending from the internal driving circuit 22 to the address input circuit 23b and, in the illustrated example, the former is shorter than the latter.

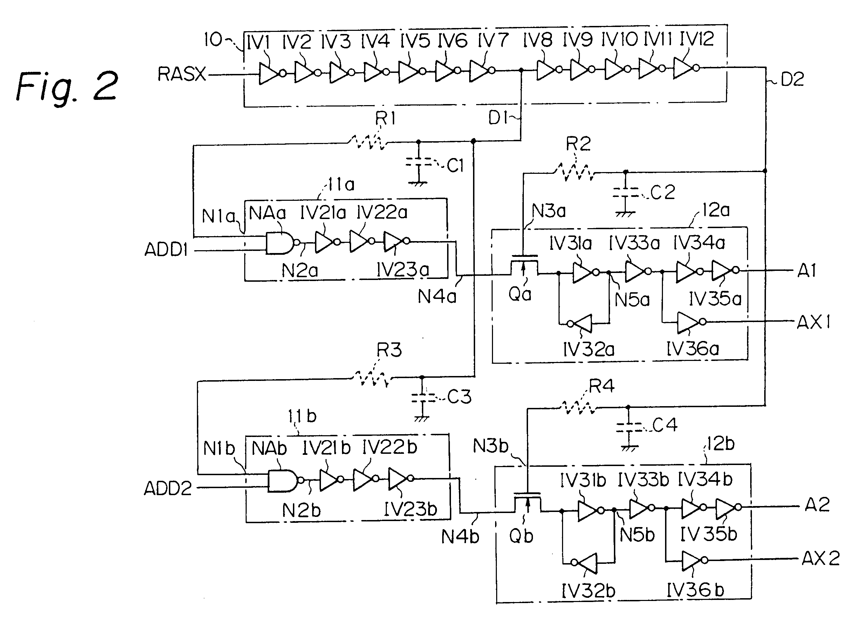

Figure 2 illustrated a constitution of the first stage of the address input circuit in a previously-considered semiconductor memory device.

In the illustration, a RASX input and driving circuit 10, corresponding to the internal driving circuit 22, is constituted by twelve inverters IV1 to IV12 connected in series and outputs control signals D1, D2 in response to a row address strobe signal RASX. Also, an address input and driving circuit 11a (11b) and an address buffer 12a (12b) in combination correspond to the address input circuit 23a (23b). The address input and driving circuit 11a (11b) is constituted by a NAND gate NAa (NAb) receiving an address signal ADD1 (ADD2) and three inverters IV21a to IV23a (IV21b to IV23b) connected in series, and activated in response to the control signal D1. On the other hand, the address buffer 12a (12b) is constituted by an N-channel transistor Qa (Qb) responsive to the control signal D2 and transmitting an output signal (address) of the address input and driving circuit 11a (11b), two inverters IV31a, IV32A (IV31b, IV32b) for latching the address transmitted via the transistor, an inverter IV33a (IV33b) responsive to the latched output, two inverters IV34a, IV35a (IV34b, IV35b) connected in series and outputting an address signal A1 (A2) in response to an output of the inverter IV33a (IV33b), and an inverter IV36a (IVV36b) responsive to the output of the inverter IV33a (IV33b) and outputting a complementary address signal AX1 (AX2).

Also, references R1 (R3) and C1 (C3) indicated by broken lines denote parasitic resistance and parasitic capacitance, respectively, of the wiring connecting the RASX input and driving circuit 10 and the address input and driving circuit 11a (11b). On the other hand, references R2 (R4) and C2 (C4) indicated by broken lines denote parasitic resistance and parasitic capacitance, respectively, of the wiring connecting the RASX input and driving circuit 10 and the address buffer 12a (12b).

As stated previously, the length of the wiring extending from the internal driving circuit 22 (10) to the address input circuit 23a (11a, 12a) is shorter than that extending from the internal driving circuit 22 (10) to the address input circuit 23b (11b, 12b), and thus, the following relationship is formed between values of each element;

$$[R1] < [R3], [C1] < [C3]$$

and

$$[R2] < [R4], [C2] < [C4].$$

The parasitic resistances R1 to R4 and parasitic capacitances C1 to C4 in combination constitute a delay circuit. As a result, the control signals D1 and D2 output from the internal driving circuit 22 (10) reach input nodes N1a, N3a of the address input circuit 23a (11a, 12a) slightly delayed and then reach input nodes N1b, N3b of the address input circuit 23b (11b, 12b) delayed slightly more.

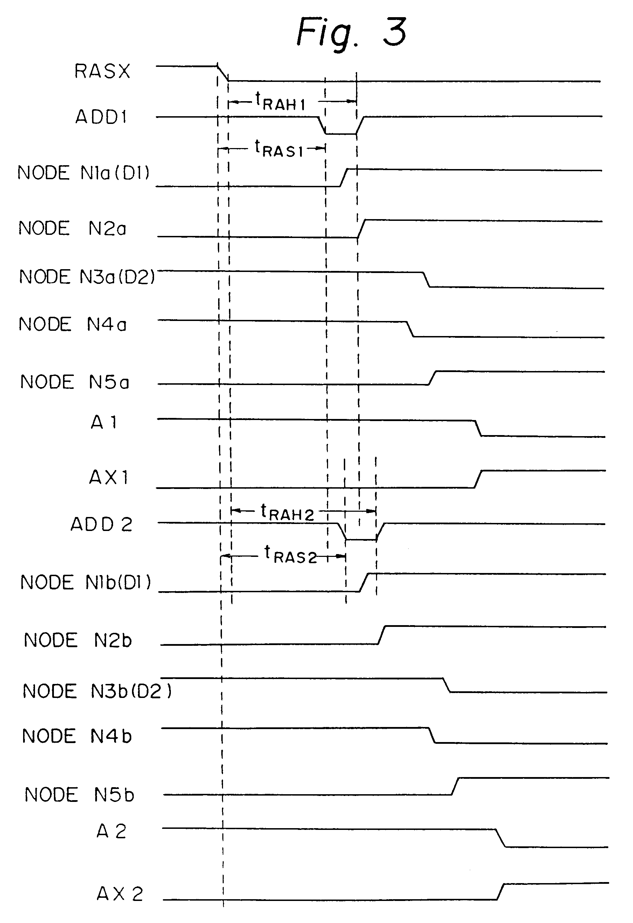

Figure 3 illustrates a timing chart of each signal in the circuit of Fig. 2.

In the illustrated timing chart, references $t_{RAS1}$ and $t_{RAS2}$ represent "row address setup time". The row address setup time is defined by the time from when the row address strobe signal RASX is changed from "H" level to "L" level until the address signal ADD1, ADD2 is changed from "H" level to "L" level. Also, references $t_{RAH1}$ and $t_{RAH2}$ represent "row address hold time". The row address hold time is defined by the time from when the row address strobe signal RASX is changed from "H" level to "L" level until the address signal ADD1, ADD2 is changed from "L" level to "H" level.

In the Figure 2 circuit constitution, since the address input circuits 23a and 23b (11a, 12a and 11b, 12b) are arrayed on shorter sides and/or longer sides of the chip 20 and thus the length of the wiring between the RASX input and driving circuit 22 (10) and the circuit 23a is different from that between the circuit 22 (10) and the circuit 23b, the level of the control signal D1 (D2) to be fed from the driving circuit 10 to the address input circuit 11a, 11b (12a, 12b) is changed at different timings (see Fig. 3, nodes N1a, N1b and N3a, N3b).

Accordingly, a disadvantage can occur in that the row address setup time ($t_{RAS1}$, $t_{RAS2}$) and row address hold time ($t_{RAH1}$, $t_{RAH2}$) necessary for the address inputting are changed depending on the location of the circuits 23a, 23b receiving the address signals ADD1, ADD2. As a result, the performance of the device (chip) is determined by the worst (i.e., longest) row address setup time and row address hold time (in the illustration of Fig. 3, $t_{RAS2}$ and $t_{RAH2}$ corresponding to the address input circuit 23b).

Also, where there is dispersion in each of the row address setup time and row address hold time, it becomes necessary to allow a certain margin for the cycle time for address accessing. This results in a drawback in that the access operation cannot be carried out at a desirably high speed. If the margin is insufficient for the cycle time, there is a possibility that the access operation will be incorrectly carried out.

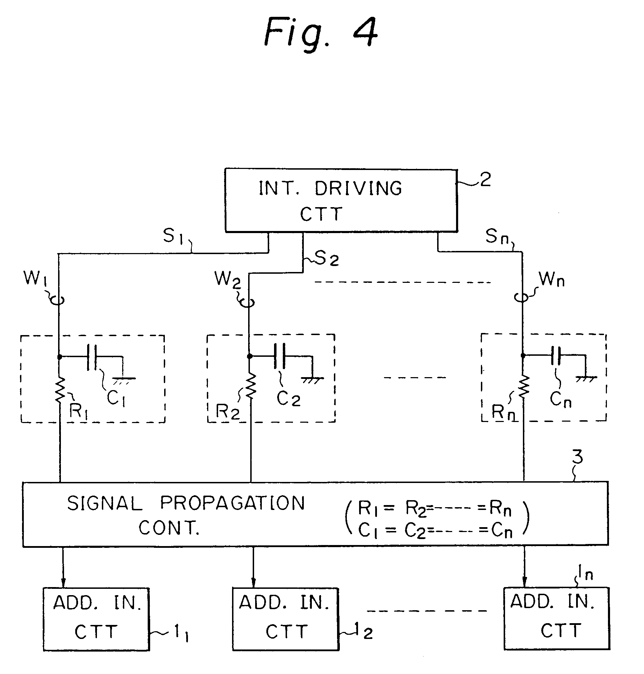

Next, preferred embodiments of the present invention will be explained with reference to Figs. 4 to 8.

Figure 4 illustrates an example of the constitution of the first stage of the address input circuit in a semiconductor memory device embodying the present invention.

In the illustration, references $1_1$ to 1n denote address input circuits which are arrayed along a periphery of a semiconductor chip; reference 2 denotes an internal driving circuit which outputs a plurality of control signals $S_1$ to Sn each driving a corresponding one of the plurality of address input circuits; and reference 3 denotes a signal propagation control unit operatively connected between the internal driving circuit and the plurality of address input circuits. The signal propagation control unit 3 controls the individual signal propagations of the plurality of control signals so as to better equalise the amount of signal propagation delay, defined by total resistance $R_1$ to Rn and total capacitance $C_1$ to Cn in each of a plurality of wirings $W_1$ to Wn transmitting the plurality of control signals, respectively.

In the above constitution, the respective amounts of signal propagation delay in each of the wirings $W_1$ to Wn extending from the internal driving circuit 2 to the address input circuit $1_1$ to 1n, respectively, are substantially equal, regardless of the location of the address input circuits $1_1$ to 1n. Thus, the individual control signals $S_1$ to Sn output from the internal driving circuit 2 reach the corresponding ad-

dress input circuit $1_1$ to $1n$, via the signal propagation control unit 3, substantially simultaneously.

Therefore, the row address setup time ($t_{RAS}$) and row address hold time ($t_{RAH}$) necessary for the address inputting are made substantially equal for the various wirings, regardless of the location of the address input circuits $1_1$ to $1n$, i.e., address input terminals. Thus, dispersion in the individual row address setup times and row address hold times is significantly reduced. This contributes to a high speed access operation.

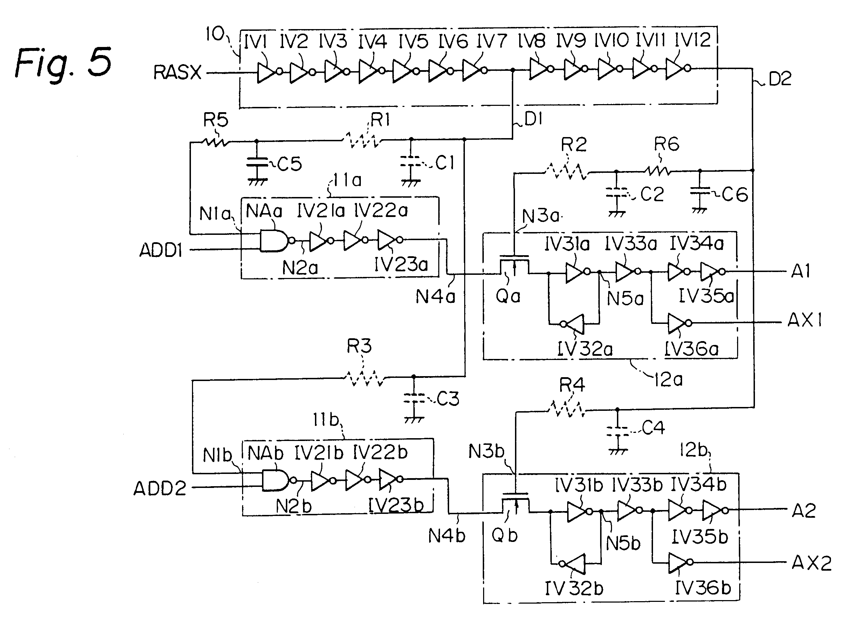

Figure 5 illustrates a constitution of the first stage of the address input circuit in a semiconductor memory device according to an embodiment of the present invention.

Note, for simplification of the illustration, a circuit constitution responsive to an address signal of two bits (ADD1, ADD2) is shown. In Fig. 5, the same references as those employed in Fig. 2 indicate like constituent elements and thus the explanation thereof is omitted.

In the Figure 5 circuitry, each of the circuits 10, 11a, 11b, 12a and 12b is disposed according to the location shown in Fig. 1. Namely, seen from the RASX input and driving circuit 10 (corresponding to the internal driving circuit 22), the address input and driving circuit 11a and address buffer 12a (corresponding to the address input circuit 23a) are disposed at a nearer position than the address input and driving circuit 11b and address buffer 12b (corresponding to the address input circuit 23b).

Also, references R5 and C5 denote a resistor and a capacitor, respectively, inserted into the wiring connecting the RASX input and driving circuit 10 and the address input and driving circuit 11a. References R6 and C6 denote a resistor and a capacitor, respectively, inserted into the wiring connecting the RASX input and driving circuit 10 and the address buffer 12a. In this case, values of each element inserted into the wiring are selected such that the following relationship is formed between them and the values of parasitic resistances R1 to R4 and parasitic capacitances C1 to C4;

$$[R1] + [R5] = [R3], [C1] + [C5] = [C3]$$
and
$$[R2] + [R6] = [R4], [C2] + [C6] = [C4].$$

In the Figure 5 circuit constitution, the resistors R5, R6 and capacitors C5, C6 having the predetermined resistance value and capacitance value satisfying the above relationship are intentionally inserted into the wiring(s) corresponding to the address input circuit 23a (the address input and driving circuit 11a and address buffer 12a) which is disposed at the nearer position, seen from the internal driving circuit 22 (the RASX input and driving circuit 10) on the chip 20 (see Fig. 1).

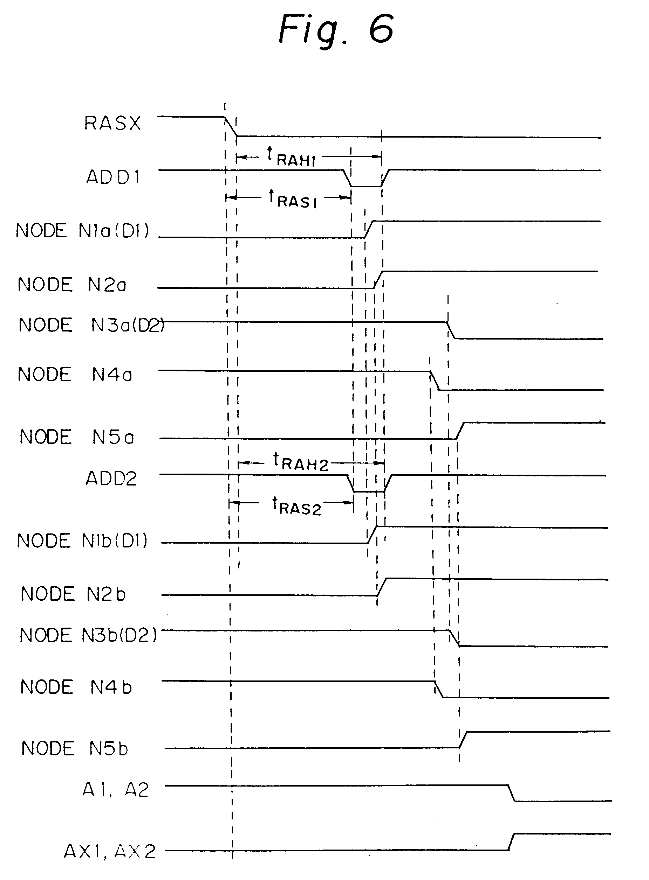

Therefore, as shown in the timing chart of Fig. 6, which illustrates the operation of the circuit of Fig. 5, the control signals D1 and D2 output from the internal driving circuit 22 (10) simultaneously reach input nodes N1a, N1b and N3a, N3b, respectively, of the address input circuits 23a (11a, 12a) and 23b (11b, 12b). Namely, it is possible to significantly reduce the difference in the propagation times of the control signal D1 (D2) transmitted to the input nodes N1a and N1b (N3a and N3b).

Whereas in the Figure 2 circuitry the row address setup time ($t_{RAS}$) and row address hold time ($t_{RAH}$) of each address signal can vary depending on the location of the address signal terminals, the Figure 5 circuitry facilitates a reduction in dispersion of the individual row address setup times and row address hold times, regardless of the location of the address signal terminals. As a result, it becomes possible to reduce the margin for the cycle time for address accessing. This is preferable from the viewpoint of a high speed access operation.

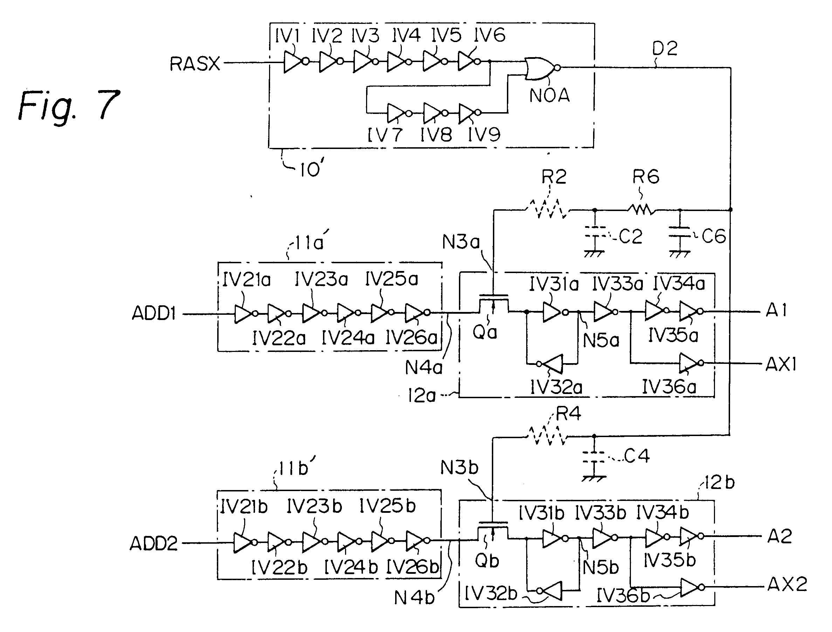

Figure 7 illustrates a constitution of the first stage of the address input circuit according to another embodiment of the present invention.

The constitution of the Figure 7 circuitry is different from that of the embodiment of Fig. 5 in that : ① in place of the RASX input and driving circuit 10, a RASX input and driving circuit 10' is provided which is constituted by nine inverters IV1 to IV9 and a NOR gate NOA; ② in place of the address input and driving circuit 11a (11b), an address input and driving circuit 11a' (11b') is provided which is constituted by six inverters IV21a to IV26a (IV21b to IV26b); and ③ a wiring which transmits the control signal D1 for activating the first stage of the address input and driving circuit 11a'(11b') is not provided, i.e., the parasitic resistances R1, R3 and parasitic capacitances C1, C3 are not present.

Other constitutions, the operation thereof and the effects achieved thereby are the same as those of the embodiment of Fig. 5, and thus, the explanation thereof is omitted.

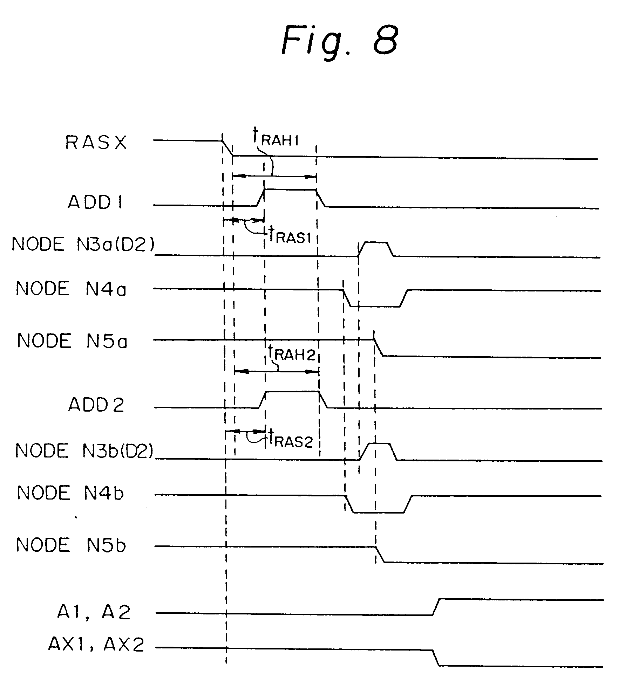

Figure 8 illustrates a timing chart of each signal in the circuit of Fig. 7. Note, in this case, the row address setup time ($t_{RAS1}$, $t_{RAS2}$) is defined by the time from when the row address strobe signal RASX is changed from "H" level to "L" level until the address signal ADD1, ADD2 is changed from "L" level to "H" level. On the other hand, the row address hold time ($t_{RAH1}$, $t_{RAH2}$) is defined by the time from when the row address strobe signal RASX is changed from "H" level to "L" level until the address signal ADD1, ADD2 is changed from "H" level to "L" level.

Although, in the above described embodiments, the circuit constitution having two address input terminals is explained, this is not a restriction. In general, where a suitable delaying element (resistance and capacitance) is incorporated in each of wirings corresponding to address input circuits other than an address input circuit which has the longest length of wiring from the internal driving circuit, it is possible to substantially remove dispersion in each of the row address setup time ($t_{RAS}$) and row address hold time ($t_{RAH}$) necessary for the address inputting, regardless of the location of the address input circuits, i.e., the address input terminals. This leads to a high speed access operation and thus is preferable.

Although the present invention has been disclosed and described by way of two embodiments, it is apparent to those skilled in the art that other embodiments and modifications of the present invention are possible without departing from the essential features thereof.

**Claims**

1. A semiconductor memory device comprising:
a plurality of address input circuits ($1_1, 1_2, ..., 1n$) disposed dispersively;
an internal driving circuit (2) outputting a plurality of control signals ($S_1, S_2, ..., Sn$) each driving a corresponding at least one of the plurality of address input circuits;
characterised by a signal propagation control means (3), operatively connected between the internal driving circuit and the plurality of address input circuits, for controlling a respective signal propagation of said plurality of control signals such that a respective amount of signal propagation delay in each of a plurality of wirings ($W_1, W_2, ..., Wn$) transmitting the plurality of control signals, respectively, is made substantially equal between each wiring.

2. A semiconductor memory device as set forth in claim 1, wherein said signal propagation control means comprises a delay circuit including a resistor (R5, R6) connected in series with each wiring and having a predetermined resistance value and a capacitor (C5, C6) connected in parallel with each wiring and having a predetermined capacitance value.

3. A semiconductor memory device as set forth in claim 2, wherein said delay circuit is incorporated in each of wirings corresponding to address input circuits other than an address input circuit which has the longest length of wiring from said internal driving circuit thereto.

4. A semiconductor memory device as set forth in claim 2, wherein said internal driving circuit comprises a circuit (10) which outputs first and second control signals (D1, D2) in response to a row address strobe signal (RASX), a predetermined delay time being selected between the first and second control signals.

5. A semiconductor memory device as set forth in claim 4, wherein each of said plurality of address input circuits comprises a circuit (11a, 11b) which effects a setup of a corresponding address bit (ADD1, ADD2) in response to said first control signal (D1), and a circuit (12a, 12b) which holds the setup address bit in response to said second control signal (D2).

6. A semiconductor memory device as set forth in claim 3, wherein said internal driving circuit comprises a circuit (10') which outputs a latch control signal (D2) in response to a row address strobe signal (RASX).

7. A semiconductor memory device as set forth in claim 6, wherein each of said plurality of address input circuits comprises a circuit (11a', 11b') which effects a setup of a corresponding address bit (ADD1, ADD2), and a circuit (12a, 12b) which holds the setup address bit in response to said latch control signal (D2).

**Patentansprüche**

1. Eine Halbleiterspeicheranordnung mit:
einer Vielzahl von Adresseneingangsschaltungen ($1_1, 1_2, ..., 1n$), die verstreut angeordnet sind;
einer internen Treiberschaltung (2), die eine Vielzahl von Steuersignalen ($S_1, S_2, ., Sn$) ausgibt, von denen jedes wenigstens eine entsprechende von der Vielzahl von Adresseneingangsschaltungen steuert;
gekennzeichnet durch ein Signalausbreitungssteuermittel (3), das zwischen der internen Treiberschaltung und der Vielzahl von Adresseneingangsschaltungen operativ verbunden ist, zum Steuern einer jeweiligen Signalausbreitung von der genannten Vielzahl von Steuersignalen, so daß ein jeweiliger Signalausbreitungsverzögerungsbetrag in jeder von einer Vielzahl von Verdrahtungen ($W_1, W_2, ..., Wn$), die die Vielzahl von jeweiligen Steuersignalen übertragen, zwischen jeder Verdrahtung im wesentlichen gleichgemacht wird.

2. Eine Halbleiterspeicheranordnung nach Anspruch 1, bei der das genannte Signalausbreitungssteuermittel eine Verzögerungsschaltung umfaßt, mit einem Widerstand (R5, R6), der mit jeder Verdrahtung seriell verbunden ist und einen vorbestimmten Widerstandswert hat, und einem Kondensator (C5, C6), der mit jeder Verdrahtung parallel verbunden ist und einen vorbestimmten Kapazitätswert hat.

3. Eine Halbleiterspeicheranordnung nach Anspruch 2, bei der die genannte Verzögerungsschaltung in jeder der Verdrahtungen inkorporiert ist, die den Adresseneingangsschaltungen entsprechen, außer bei einer Adresseneingangsschaltung, die die längste Verdrahtungslänge von der genannten internen Treiberschaltung bis zu sich hat.

4. Eine Halbleiterspeicheranordnung nach Anspruch 3, bei der die genannte interne Treiberschaltung eine Schaltung (10) umfaßt, die als Reaktion auf ein Reihenadressen-Strobe-Signal (RASX) erste und zweite Steuersignale (D1, D2) ausgibt, wobei zwischen den ersten und zweiten Steuersignalen eine vorbestimmte Verzögerungszeit gewählt wird.

5. Eine Halbleiterspeicheranordnung nach Anspruch 4, bei der jede von der genannten Vielzahl von Adresseneingangsschaltungen eine Schaltung (11a, 11b) umfaßt, die einen Aufbau eines entsprechenden Adressenbits (ADD1, ADD2) als Reaktion auf das genannte erste Steuersignal (D1) bewirkt, und eine Schaltung (12a, 12b), die das aufgebaute Adressenbit als Reaktion auf das genannte zweite Steuersignal (D2) hält.

6. Eine Halbleiterspeicheranordnung nach Anspruch 3, bei der die genannte interne Treiberschaltung eine Schaltung (10′) umfaßt, die ein Verriegelungssteuersignal (D2) als Reaktion auf ein Reihenadressen-Strobe-Signal (RASX) ausgibt.

7. Eine Halbleiterspeicheranordnung nach Anspruch 6, bei der jede von der genannten Vielzahl von Adresseneingangsschaltungen eine Schaltung (11a′, 11b′) umfaßt, die einen Aufbau eines entsprechenden Adressenbits (ADD1, ADD2) bewirkt, und eine Schaltung (12a, 12b), die das aufgebaute Adressenbit als Reaktion auf das genannte Verriegelungssteuersignal (D2) hält.

**Revendications**

1. Dispositif de mémoire à semi-conducteur comprenant :
   - une pluralité de circuits d'entrée d'adressage ($1_1$, $1_2$, ..., $1_n$) placés de façon dispersée;
   - un circuit interne de pilotage (2) délivrant une pluralité de signaux de commande ($S_1$, $S_2$, ..., $S_n$) qui pilotent chacun au moins un circuit correspondant de la pluralité de circuits d'entrée d'adressage;
   dispositif caractérisé par un moyen (3) de commande de propagation de signal fonctionnellement raccordé, entre le circuit interne de pilotage et la pluralité de circuits d'entrée d'adressage pour commander la propagation de signal respective de ladite pluralité de signaux de commande de telle façon que la valeur respective du retard de propagation de signal intervenant dans chaque câblage d'une pluralité de câblages ($W_1$, $W_2$, ... $W_n$) transmettant respectivement la pluralité de signaux de commande soit rendue pratiquement la même dans tous les câblages.

2. Dispositif de mémoire à semi-conducteur selon la revendication 1, dans lequel ledit moyen de commande de propagation de signal comprend un circuit de retard comportant une résistance (R5, R6) montée en série avec chaque câblage et possédant une valeur prédéterminée de résistance et un condensateur (C5, C6) monté en parallèle avec chaque câblage et possédant une valeur prédéterminée de capacité.

3. Dispositif de mémoire à semi-conducteur selon la revendication 2, dans lequel ledit circuit de retard est incorporé dans chacun des câblages correspondant aux circuits d'entrée d'adressage autres que le circuit d'entrée d'adressage qui présente la plus grande longueur de câblage entre lui-même et ledit circuit interne de pilotage.

4. Dispositif de mémoire à semi-conducteur selon la revendication 3, dans lequel ledit circuit interne de pilotage comprend un circuit (10) qui délivre des premier et second signaux de commande (D1, D2) en réponse à un signal de transfert d'adresse de rangée (RASX), un temps prédéterminé de retard étant choisi entre les premier et second signaux de commande.

5. Dispositif de mémoire à semi-conducteur selon la revendication 4, dans lequel chaque circuit de ladite pluralité de circuits d'entrée d'adressage comprend un circuit (11a, 11b) qui effectue l'établissement d'un bit d'adressage correspondant (ADD1, ADD2) en réponse audit premier signal de commande (D1), et un circuit (12a, 12b) qui maintient le bit d'adressage établi en réponse audit second signal de commande (D2).

6. Dispositif de mémoire à semi-conducteur selon la revendication 3, dans lequel ledit circuit interne de pilotage comprend un circuit (10′) qui délivre un signal de commande de verrouillage (D2) en réponse à un signal de transfert d'adresse de rangée (RASX).

7. Dispositif de mémoire à semi-conducteur selon la revendication 6, dans lequel chaque circuit de ladite pluralité de circuits d'entrée d'adressage comprend un circuit (11a', 11b') qui effectuent l'établissement d'un bit d'adressage correspondant (ADD1, ADD2), et un circuit (12a, 12b) qui maintient le bit d'adressage établi en réponse audit signal de commande de verrouillage (D2).

# Fig. 1

Fig. 2

EP 0 425 275 B1

# Fig. 3

# Fig. 4

Fig. 5

# Fig. 6

EP 0 425 275 B1

*Fig. 7*

# Fig. 8